# EUROPÄISCHE PATENTANMELDUNG

(11) **EP 1 674 641 A1**
(43) Veröffentlichungstag der Anmeldung: **28.06.2006**
(21) Anmeldenummer: 05013355.2
(22) Anmeldetag: 21.06.2005
(51) Int. Cl.: E05B 17/22, E05B 1/00, H03K 17/96

(54) **Vorrichtung zum Betätigen eines elektrischen Schliesssystems und/oder eines in der Tür oder Klappe oder dergleichen eingebauten Schlosses für Fahrzeuge**

(30) Priorität: 22.12.2004 DE 102004063009
(71) Anmelder: Huf Hülsbeck & Fürst GmbH & Co. KG, 42551 Velbert (DE)
(72) Erfinder: Simon, Jörg, D-42489 Wülfrath (DE); Steegmann, Bernd, D-42579 Heiligenhaus (DE); Herzog, Thomas, 42283 Wuppertal (DE)

(57) **Zusammenfassung**

Die Erfindung betrifft eine Vorrichtung zum Betätigen eines elektrischen Schließsystems und / oder eines in der Tür, einer Klappe oder dergl. eingebauten Schlosses, für Fahrzeuge. Bei derartigen Vorrichtungen ist an der Außenseite der Tür oder einer Klappe ein Griff angeordnet, der elektrische Bauteile zur Aktivierung von Schließfunktionen oder anderen Funktionen beinhaltet. Die Funktionen werden durch Betätigung von Sensoren bzw. Schalter aktiviert, wobei Signale zur Steuereinheit eines Fahrzeuges oder zu Schlössern zu leiten sind. Die Sensoren sind am Griff integriert und von außen sichtbar und zugänglich und den Umwelteinflüssen ausgesetzt sowie vielen Schaltzyklen ausgesetzt. Zur Vermeidung von Abdichtungsproblemen, insbesondere gegen Feuchtigkeit, und Vandalismusschäden, sowie zur Erreichung einer langen Lebensdauer wird als Sensor ein piezoelektrischer Sensor verwendet.

## Beschreibung

Die vorliegende Erfindung betrifft eine Vorrichtung zum Betätigen eines elektrischen Schließsystems und / oder eines in der Tür, einer Klappe oder dergl. eingebauten Schlosses für Fahrzeuge, mit mindestens einem an der Handhabe angeordneten oder an der Außenhaut des Fahrzeuges angeordneten Sensors, womit ein Steuerbefehl aktiviert werden kann.

Aus der DE 199 43 986 A1 ist eine Vorrichtung eines elektrischen Schließsystems bekannt, wobei im beweglichen Türaussengriff Schaltsensoren integriert sind, um zum einen den Entriegelungsvorgang des Schlosses zu aktivieren und mittels eines weiteren Schalters die Schlösser des Fahrzeuges zu verriegeln.
Bei beiden Schaltern handelt es sich um mechanische Schaltelemente, die u.a. Mikroschalter enthalten.
Der Aufbau eines solchen Druckschalters wird in der DE 198 56 902 A1 beschrieben.
Mit aufwendigen Mitteln, wie Gummimembranen und Dichtungselementen müssen die Schaltelemente gegen Umwelteinflüsse geschützt werden. Insbesondere gegen Spritzwasser und Staub, das bei Eindringen zu Kurzschlüssen führt und damit das Schließsystem außer Funktion setzt.
In aufwendigen Herstellverfahren müssen die Dichtungselemente mit dem Griff wasserdicht verbunden werden. Überdruckreaktionen durch Luftausdehnung bei hohen Temperaturen müssen berücksichtigt sein und machen die Konstruktion aufwendig.

Es müssen Anschläge in der Konstruktion vorgesehen werden, um ein Durchdrücken und damit die Zerstörung eines Mikroschalters, zu vermeiden. Des weiteren sind diese Schalter von außen durch die unterschiedliche Materialpaarung leicht sichtbar und zugänglich und somit dem Vandalismus ausgesetzt.

Aus der DE 199 61 246 A1 sind Vorrichtungen eines elektrischen Schließsystems bekannt, wobei ein Schaltsensor hinter einem elastischen Karosserieblech angeordnet ist oder hinter einem elastisch verformbaren Bereich einer Fahrzeugaußenverkleidung, wie z.B. einem Fahrzeugemblem. Es wird jeweils ein Mikroschalter zur Signalerzeugung verwendet.

Nachteilig bei der Verwendung von Mikroschaltern ist die begrenzte Zahl von Schaltzyklen. Häufig fallen mechanische Schalter wegen des Ausfalls mechanischer Bauteile aus. Der Bauraum der bei Verwendung von Mikroschaltern nötig ist, ist erheblich.

Die Verwendung eines kapazitiven Schaltelementes bei Fahrzeugschließsystemen, wie es in der DE 196 17 038 A1 beschrieben ist, hat den Nachteil, dass kapazitive Schaltelemente zu Fehlauslösungen neigen, die insbesondere durch äußere Einflüsse, wie Regen oder Schnee, verursacht werden. Problematisch sind zudem elektrische Aufladungen, die zu Problemen führen.

Es ist somit Aufgabe der Erfindung eine Vorrichtung zum Betätigen eines Schließsystems für Kraftfahrzeuge zu schaffen, das bezüglich der Schaltfunktion eine lange Lebensdauer aufweist, geringen Bauraum beansprucht, flexible Anwendungsmöglichkeiten bietet, unempfindlich gegen Luftdruckschwankungen und unkritisch gegen Umwelteinflüsse und Vandalismus ist.

Zur Lösung dieser Aufgabe dienen die Merkmale des Anspruchs 1 und 2.

Die Erfindung sieht in vorteilhafterweise vor, dass ein piezoelektrischer Sensor zur Steuerung des elektrischen Schließsystems verwendet wird.

Dieser Sensor läßt sich in einfacher Weise in einen Türgriff oder an der Außenhaut des Fahrzeuges leicht integrieren und benötigt nur geringen Bauraum.

Piezoelektrische Sensoren ermöglichen nahezu unendlich viel Schaltzyklen bei hoher Schaltgeschwindigkeit.
Es können mehrere piezoelektrische Sensoren für unterschiedliche Funktionen am Türgriff oder an der Außenhaut des Fahrzeuges angeordnet sein. Beispielhaft sind für solche Schließfunktionen einfaches Sichem, doppeltes Sichern, so daß auch von innen kein Öffnen mehr möglich ist, Einschalten der Alarmanlage oder Einklappen des Außenspiegels.

Vorzugsweise wird der Sensor in einer beweglichen Handhabe verwendet.

Vorzugsweise wird der Sensor in einer unbeweglichen Handhabe verwendet. Durch den Druck auf das Piezo-Element und dem damit verbundenen Signalerzeugung erübrigt sich eine aufwendige Mechanik zur Ausgestaltung eines beweglichen Griffes.

Vorzugsweise ist vorgesehen, dass das piezoelektrische Element hinter einem nachgiebigen Teil des Fahrzeuges angeordnet ist und durch Druck von der gegenüberliegenden Seite auf das nachgiebige Fahrzeugteil betätigt wird, so dass ein Signal erzeugt und an das Steuergerät eines Schließsystems oder eines Schlosses geleitet wird.

Das piezoelektrische Element wird aus einem piezoelektrischen Lack gebildet. Dieser wird auf einer Elektrodenfläche aufgebracht, die auf der Handhabe oder an einem Fahrzeugteil angeordnete ist. Abschließend ist der piezoelektrische Lack von einer Schutzschicht, die der Fahrzeuglack bilden kann, überzogen.

Vorzugsweise ist zwischen dem piezoelektrischen Lack und der Schutzschicht und/oder dem Lack eine zweite Elektrodenfläche angeordnet.

Das piezoelektrische Element kann alternativ als piezoelektrische Folie auf die Außenhaut des Fahrzeuges oder einer Handhabe aufgebracht sein.

Vorteilhaft ist vorgesehen, dass durch unterschiedliche Krafteinwirkung auf den Sensor, unterschiedliche Funktionen ausgelöst werden, wie beispielsweise einfaches Sichem, doppeltes Sichem, so daß auch von innen kein Öffnen mehr möglich ist, Einschalten der Alarmanlage oder Einklappen des Außenspiegels, Schließen der Fenster oder Öffnen des Fahrzeuges, Start der Identifikationsabfrage.

Durch Betätigung des Sensors wird ein Ausgangssignal erzeugt, das an ein Steuergerät weitergeleitet wird. Das Steuergerät löst aufgrund des ausgewerteten Signals eine entsprechende Funktion aus.

Vorzugsweise ist vorgesehen, dass nur ein Sensorelement verwendet wird, wobei durch die Signalerzeugung zwischen zwei Funktionzuständen hin- und hergeschaltet wird.

Im folgenden wird unter Bezugnahme auf die Zeichnungen Ausführungsbeispiel der Erfindung erläutert:

Es zeigen:
- Fig. 1 :: perspektivische Ansicht eines Türaußengriffs eines Fahrzeugs, an welchem die erfindungsgemäße Vorrichtung realisiert ist.
- Fig. 2 :: einen horizontalen Teilschnitt des Sensorbereiches des in Fig. 1 gezeigten Türaußengriffs,
- Fig. 3 :: einen im wesentlichen horizontalen Längsschnitt durch einen Türaußengriff in einer alternativen Ausgestaltung

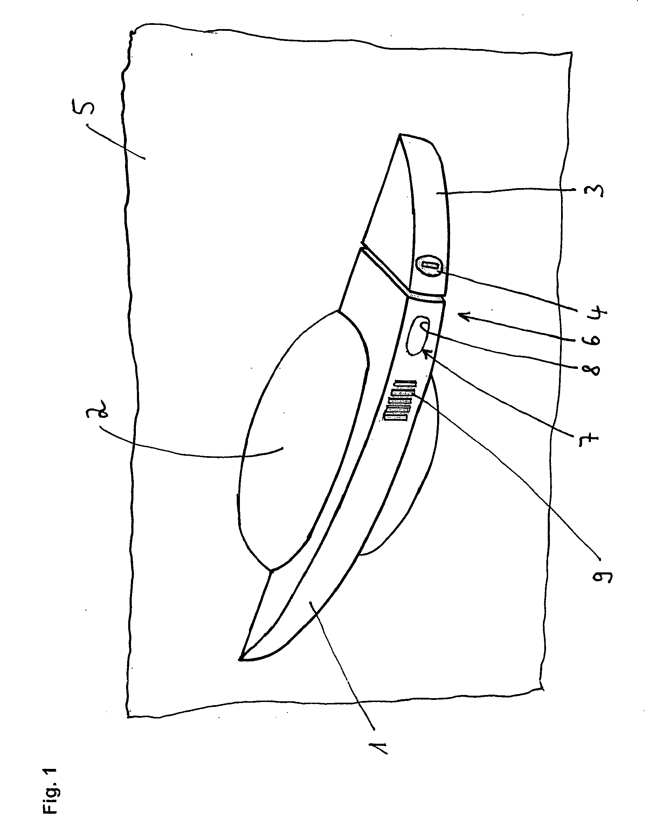

Fig.1 zeigt einen beweglichen Türaußengriff 1 (Handhabe) eines Kraftfahrzeuges mit Passiv-entry Funktion in perspektivischer Ansicht.
Beim Passiv-Entry-System trägt der Fahrzeugbediener einen ID-Geber, der zur Kommunikationsabfrage vom Fahrzeug aktiviert wird. Die Entriegelung findet ohne Benutzung eines Schlüssel oder aktive Bedienung eines Funkschlüssels aufgrund einer
Codefreigabe statt.

Es handelt sich um einen Ziehgriff, der durch Eingreifen der Hand in die Griffmulde 2, die in das Türblech geformt ist, gegriffen werden kann, um ihn dann nach außen zu ziehen, wodurch das Schloß, wenn es entriegelt ist, geöffnet wird, d.h. die Drehfalle im Schloß freigegeben wird.
In der Verlängerung des Türgriffs 1 schließt sich die Abdeckung 3 der Aufnahme des Schließzylinders 4 an.

Im hinteren Bereich 6 des Türgriffs 1 ist ein piezoelektrischer Sensor 7 integriert, der hinter der Lackierung oder Oberflächenbeschichtung des Türgriffs 1 und somit geschützt vor Umwelteinflüssen, angeordnet ist. Die Lage des piezoelektrischen Sensors 7 ist durch eine Vertiefung 8 (Mulde) erkennbar und für den Anwender ertastbar. Als Oberflächenbeschichtung kann eine Kunststoffbeschichtung verwendet werden. Die Beschichtung kann nachträglich aufgetragen oder im Spritzgießverfahren erzeugt werden.
Daneben ist ein zweiter piezoelektrischer Sensor in gleicher Weise angeordnet, dessen Abdeckfläche 9 zur besseren Erkennbarkeit und Ertastbarkeit gerippt ausgeführt ist.

Der erste piezoelektrische Sensor 7 aktiviert bei Betätigung die Identitätsabfrage des Schließsystems, d.h. es wird eine Kommunikation zwischen dem vom Fahrzeugbediener mitgeführten ID-Geber und der zentralen Steuereinheit des Kraftfahrzeuges gestartet, wobei die Zugangsberechtigung übe Code-Informationen geprüft wird. Nach positiver Auswertung werden die Schlösser des Fahrzeuges entriegelt, so danach durch Betätigung des Türgriffs eine Öffnung des Schlosses erst möglich wird.

Der zweite Sensor hinter der Abdeckung 9 dient zur Aktivierung des Schließbefehls. d.h. bei Betätigung durch den Fahrzeugbediener werden die Schlösser des Kraftfahrzeugs verriegelt, so dass eine Öffnung durch Betätigung des Türgriffs gesperrt ist. Je nach Anzahl der gewünschten Funktionen kann die Zahl der zum Einsatz kommenden piezoelektrischen Sensoren variiert werden.

Jeder piezoelektrische Sensor kann alternativ auf der zum Fahrzeug hingewandten Innenseite des Türgriffs 1 integriert sein, oder auch auf der Ober- oder Unterseite des Türgriffes 7.

Es wäre auch denkbar, dass die piezoelektrischen Sensoren auf der Abdeckung 3 des Schließzylinders 4 anordnet sind.

Im Fall der Verwendung nur eines oder nur weniger piezoelektrischen Sensoren besteht die Möglichkeit diese Sensoren mehrfach mit Funktionen auszustatten.
Die Art der Funktion wird durch die aufgebrachte Kraft ausgewählt. Bei geringer Kraftaufbringung wird nur eine geringe Spannung erzeugt, die in einer Auswerteeinheit 10 verarbeitet und ausgewertet wird, woraufhin die Auswerteeinheit, ggf. über eine Datenbusleitung eine Funktion aktiviert. Bei großer Kraftaufbringung wird eine höhere Spannung erzeugt, die wiederum von einer Auswerteeinheit 10 ausgewertet wird wodurch eine andere Funktion aktiviert wird. Mehrere Stufungen der Kraftaufbringung für unterschiedliche Funktionen sind möglich

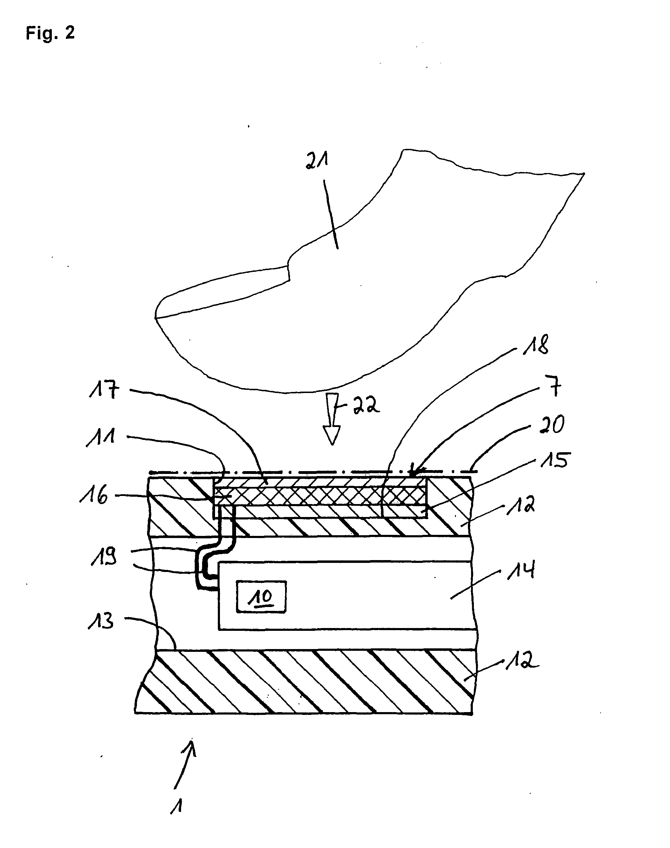

In Figur 2 ist der Aufbau des piezoelektrischen Sensors 7 im Schnitt dargestellt. Der piezoelektrische Sensor ist in einer Ausnehmung 11 in der Wandung 12 des Türgriffs 2 angeordnet. Der Türgriff 2 besteht aus Kunststoff und wird vorzugsweise im Spritzgießverfahren hergestellt, so daß eine Ausnehmung im Spritzgießvorgang einfach hergestellt werden kann. Im inneren Hohlraum des Türgriffes 1 ist eine Elektronikbaugruppe 14 untergebracht. Diese enthält Auswerteeinheiten, Sendeeinheiten, Antennen und ggf. Auswerteeinheiten für andere Sensoren. Die Auswerteeinheiten können sämtlich in einer Steuereinheit in der Elektronikbaugruppe 14 zusammengefaßt sein.

Im Bodenbereich 18 der Ausnehmung 11 des Türgriffs 1 ist eine Grundschicht 15 integriert, auf die die piezoelektrische Schicht 16 als Lack aufgebracht ist. An die piezoelektrische Schicht sind elektrische Leitungen zur Anbindung an die Auswerteeinheit 10 in der Elektronikbaugruppe 14 angeschlossen.
Auf der piezoelektrischen Schicht 16 schließt eine Abstandsschicht 17 den piezoelektrischen Sensor 7 ab.

Zur Abdichtung und zur Bildung einer einheitlichen Oberfläche ist der gesamte Trügriff 1 mit einer Lackierbeschichtung 20 versehen. Diese Lackierbeschichtung besteht aus einer oder mehreren Lackschichten und ist identisch mit der Farblackierschicht der Türgriffes (1).
Durch einen erzeugten Druck mittels eines Fingers 21 auf die Oberfläche 20 unter der sich der piezoelektrische Sensor 7 befindet, wird der Druck 22 auf die piezoelektrische Schicht 16 übertragen, wodurch eine Spannung erzeugt wird, die in der Auswerteeinheit 10 verarbeitet wird.

Die Lackierschicht 20 ist elastisch genug, um die geringen Kräfte und damit geringen Verformungen schadlos aufzunehmen.

Die Lackierschicht 20 kann alternativ als Abstandsschicht 17 verwendet werden, so daß sich eine Schicht erübrigt.
In einer weiteren alternativen Ausgestaltungsform, die hier nicht dargestellt ist, wird die piezoelektrische Schicht 16 als Folie aufgetragen, was ggf. direkt auf den Kunststoff-Grundkörper 12 des Türgriffs 1 erfolgen kann.

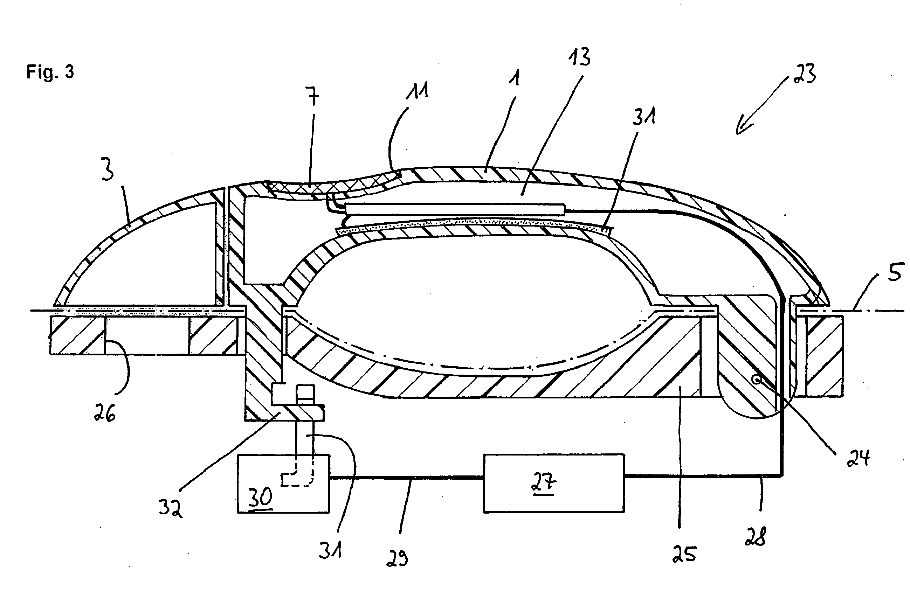

Figur 3 zeigt den Gesamtaufbau eine Türaussengriffeinheit 23 für ein Kraftfahrzeug im Gesamtaufbau im horizontalen Schnitt, bestehend aus einem Trügriff 1, der in einem Schwenklager 24 im Griffträger 25 gelagert ist und einer Abdeckung 3 für die Schließzylinderaufnahme 26, in die im Bedarfsfall ein Schließzylinder 4 eingebaut ist.

In der Ausnehmung 11 des Türgriffs 1 ist der piezoelektrische Sensor 7, wie er in Figur 2 im Detail dargestellt ist, integriert. Die Ausnehmung 11 ist muldenförmig ausgebildet, um die Fläche tastbar zumachen.
Im Hohlraum 13 bzw. Innenbereich des Türgriffs 1 befindet sich die Elektronikbaugruppe 14 , die die Auswerteeinheit 10 des piezoelektrischen Sensor 7 , Antenne, kapazitive Auswerteeinheiten und oder Sendeeinheiten zur Kommunikation mit dem ID-Geber enthält. Die Elektronikbaugruppe 14 ist mit einer Gießmasse zum Schutz vor Feuchtigkeit umgeben. Zur Signalübertragung an das zentrale Steuergerätes (27) des Fahrzeugs und zur Energieversorgung der Elektronikbaugruppe 14 ist eine elektrische Verbindungsleitung 28 aus dem Türgriff 2 heraus geführt.
Von der zentralen Steuereinheit 27 laufen Steuerleitungen 29 zum Türschloß 30. Im Innenraum des Türgriffs 1 ist an der Innenwand zur fahrzeughingewandten Seite eine kapazitive Meßfläche 31 eines kapazitiven Sensors angeordnet.
Der Griffträger 25 ist im Innenbereich des Fahrzeugaußenbleches 5 angeordnet

In diesem Ausführungsbeispiel wird durch das Umgreifen des Türgriffes 1 mit der Hand der kapazitive Sensor 31 aktiviert, wodurch die Kommunikation zur Identifikationsabfrage zwischen dem ID-Geber des Fahrzeugnutzers und der Steuereinheit 27 gestartet wird.
Nach erfolgter positiver Identifikation wird durch das Steuergerät 27 das Schloß 30 entriegelt.

Nun kann durch Ziehen am Türgriff 1, dieser um das Schwenklager 24 geschwenkt werden, wodurch der hakenförmige Ansatz 32 auf einen Hebel 33 wirkt, der im Schloß 30 die Schloßfalle freigibt und somit die Tür des Fahrzeugs zum Öffnen frei ist.
Zur Schließung des Fahrzeuges wird, nachdem die Tür in das Schloß 30 gefallen ist, durch den Fahrzeugbediener 21 der piezoelektrische Sensor 7 betätigt. Das erzeugte Signal wird in der Auswerteeinheit 10 verarbeitet und ein entsprechendes Signal über die Steuerleitungen 28 an die zentrale Steuereinheit 27 geleitet, die einen entsprechenden Auftrag zum Verriegeln an das Schloß 30 gibt. Je nachdem, wie stark der Fahrzeugbediener 21 das piezoelektrische Element kraftmäßig betätigt hat wird das Fahrzeug nur einfach verschlossen, d.h. man kann es weiterhin von innen öffnen oder doppelt verschlossen, d.h. das Fahrzeug läßt sich aus dem Innenraum heraus nicht mehr durch Betätigung der Innenbetätiger öffnen.

Alternativ kann der kapazitive Sensor bei gleicher Funktion durch ein piezoelektrischen Sensor ersetzt werden.
Insgesamt wirkt sich der geringe Bauraum, den piezoelektrische Sensoren benötigen positiv auf die Konstruktion aus . Diese Anordnung ermöglicht eine wasser- und druckdichte Abdichtung gegenüber der Umwelt.

Die Anwendung in der hier dargestellten Form ist auch auf einen unbeweglichen Türaussengriff übertragbar, der fest mit dem Türblech verbunden ist. Durch das von dem Piezoelemente erzeugte Signal erübrigt sich die aufwendige Mechanik für eine Ausführung als beweglicher Griff.

Bei Verwendung nur eines Sensors wird bei Betätigung das Signal vorzugsweise dazu verwendet, um zwischen zwei Funktionen hin- und herzuschalten. D.h. bei erster Betätigung wird beispielsweise das Signal zum Öffnen des Schließsystems gegeben, bei nochmaliger Betätigung wird der Schließbefehl gegeben usw.

## Patentansprüche

1. Vorrichtung zum Betätigen eines elektrischen Schließsystems und / oder eines in der Tür, einer Klappe oder dergl. eingebauten Schlosses (30), für Fahrzeuge, mit einer Handhabe (1) zum Öffnen eines zugehörigen Tür- oder Klappenschlosses (30) und mit mindestens einem an der Handhabe angeordneten Sensors, womit ein Steuersignal aktiviert werden kann,
**dadurch gekennzeichnet, dass** der Sensor ein piezoelektrischer Sensor (7) ist.

2. Vorrichtung zum Betätigen eines elektrischen Schließsystems und / oder eines in der Tür, einer Klappe oder dergl. eingebauten Schlosses (30), für Fahrzeuge und mit mindestens einem an der Außenhaut des Fahrzeuges angeordneten Sensor, womit ein Steuersignal aktiviert werden kann,
**dadurch gekennzeichnet, dass** der Sensor ein piezoelektrischer Sensor (7) ist.

3. Vorrichtung nach Anspruch 1 **dadurch gekennzeichnet, dass** an der Handhabe (1) mehrere piezoelektrische Sensoren (7) angeordnet sind, die jeweils Signale für unterschiedlichen Funktionen auslösen.

4. Vorrichtung nach Anspruch 1 oder 3 **dadurch gekennzeichnet, dass** die Handhabe (1) zum Öffnen eines zugehörigen Tür- oder Klappenschlosses eine bewegliche Handhabe (1) ist.

5. Vorrichtung nach Anspruch 1 oder 3 **dadurch gekennzeichnet, dass** die Handhabe (1) zum Öffnen eines zugehörigen Tür- oder Klappenschlosses eine unbewegliche Handhabe (1) ist.

6. Vorrichtung nach einem der vorhergehenden Ansprüche, **dadurch gekennzeichnet, dass** das piezoelektrische Element (7) hinter einem nachgiebigen Teil (5, 20) des Fahrzeuges angeordnet ist und durch Druck von der gegenüberliegenden Seite auf das nachgiebige Fahrzeugteil betätigt wird, so dass ein Signal erzeugt und an das Steuergerät eines Schließsystems oder eines Schlosses (30) geleitet wird.

7. Vorrichtung nach einem der vorhergehenden Ansprüche, **dadurch gekennzeichnet, dass** das piezoelektrische Element (7) aus einem piezoelektrischen Lack gebildet wird.

8. Vorrichtung nach Anspruch 6 **dadurch gekennzeichnet, dass** der piezoelektrische Lack auf einer Elektrodenfläche (15) aufgebracht ist, die auf der Handhabe (1) oder einem Fahrzeugteil angeordnet ist und der piezoelektrische Lack von einer Schutzschicht und / oder einer Lackschicht (20) überzogen ist.

9. Vorrichtung nach Anspruch 7 **dadurch gekennzeichnet, dass** zwischen dem piezoelektrischen Lack und der Schutzschicht (17) und / oder der Lackierschicht (20) eine zweite Elektrodenfläche angeordnet ist.

10. Vorrichtung nach einem der vorhergehenden Ansprüche, **dadurch gekennzeichnet, dass** das piezoelektrische Element (7) als piezoelektrische Folie auf die Außenhaut des Fahrzeuges oder einer beweglichen Handhabe (1) aufgebracht ist.

11. Vorrichtung nach einem der vorhergehenden Ansprüche, **dadurch gekennzeichnet, dass** durch unterschiedliche Krafteinwirkung auf den piezoelektrischen Sensor (7) unterschiedliche Funktionen ausgelöst werden.

12. Vorrichtung nach einem der vorhergehenden Ansprüche **dadurch gekennzeichnet, dass** nach Betätigung eines Sensors ein Ausgangssignal erzeugt und an ein Steuergerät (27) weitergeleitet wird und dass das Steuergerät (27) aufgrund dieses Ausgangssignales eine Funktion auslöst.

13. Vorrichtung nach Anspruch 3, 8 oder 9 **dadurch gekennzeichnet, dass** eine Funktion darin besteht, die Identifikationsabfrage mit nachfolgender Entriegelung des Schließsystems bei erfolgreicher Identifikation eines Benutzers zu starten.

14. Vorrichtung nach Anspruch 3, 8, 9 oder 10 **dadurch gekennzeichnet, dass** die unterschiedlichen Funktionen darin bestehen, das elektrische Schießsystem zu verriegeln und / oder eine Alarmanlage einzuschalten und / oder ein geöffnetes Fenster im Fahrzeug zu schließen und / oder die Seitenspiegel vom Fahrzeug einzuklappen.

15. Vorrichtung nach einem der vorherigen Ansprüche, **dadurch gekennzeichnet, dass** durch die jeweilige Betätigung des Sensors / der Sensoren (7) und dem damit erzeugten Signal zwischen zwei auszuführenden Funktionen hin- und hergeschaltet wird.
